# FASCICULE DE BREVET EUROPEEN

(11) **EP 3 040 711 B1**
(45) Date de publication et mention de la délivrance du brevet: **02.09.2020**
(21) Numéro de dépôt: 16150013.7
(22) Date de dépôt: 04.01.2016
(51) Int. Cl.: G01N 21/65, B82Y 15/00, B82Y 20/00

(54) **PROCEDE DE FABRICATION D'UN SUBSTRAT POUR DIFFUSION RAMAN EXALTEE DE SURFACE ET SUBSTRAT**
HERSTELLUNGSVERFAHREN EINES SUBSTRATS ZUR OBERFLÄCHENVERSTÄRKTEN RAMAN-STREUUNG, UND ENTSPRECHENDES SUBSTRAT
METHOD FOR MANUFACTURING A SUBSTRATE FOR SURFACE-ENHANCED RAMAN SCATTERING AND SUBSTRATE

(30) Priorité: 05.01.2015 FR 1550010
(43) Date de publication de la demande: 06.07.2016
(73) Titulaire: Commissariat à l'Energie Atomique et aux Energies Alternatives, 75015 Paris (FR)
(72) Inventeur: LANDIS, Stefan, 38210 Tullins (FR); REBOUD, Vincent, 75013 Paris (FR)
(74) Mandataire: Cabinet Camus Lebkiri

(56) Documents cités:
- US-A1- 2011 140 209
- US-A1- 2013 038 870
- MYEONG-LOK SEOL ET AL: "Multi-layer nanogap array for high-performance SERS substrate;Multi-layer nanogap array for high-performance SERS substrate", NANOTECHNOLOGY, IOP, BRISTOL, GB, vol. 22, no. 23, 11 avril 2011 (2011-04-11), page 235303, XP020205448, ISSN: 0957-4484, DOI: 10.1088/0957-4484/22/23/235303

## Description

### DOMAINE TECHNIQUE

Le domaine de l'invention est celui des procédés de fabrication de substrats pouvant être utilisés pour mettre en œuvre des procédés de diffusion Raman exaltée de surface (SERS). L'invention concerne également un substrat pour diffusion Raman exaltée de surface.

### ETAT DE LA TECHNIQUE ANTERIEUR

La diffusion Raman exaltée de surface (SERS) est l'une des techniques de détection les plus prometteuses pour identifier et caractériser des molécules. Cette technique consiste à déposer les molécules d'intérêt sur un substrat présentant une surface métallique rugueuse. La surface métallique sur laquelle sont fixées les molécules d'intérêt est ensuite éclairée par une lumière monochromatique. Les molécules émettent alors un signal Raman caractéristique de ces molécules, ce qui les rend détectables et identifiables.

Toutefois le signal Raman émis par les molécules présente une intensité très inférieure à l'intensité de la lumière monochromatique avec laquelle on a éclairé les molécules. Pour remédier à ce problème, on a constaté que la rugosité de la surface métallique du substrat qui porte les molécules d'intérêt permet d'exalter le signal Raman émis par les molécules d'intérêt grâce à l'excitation de plasmons localisés du métal (exaltation par effet électromagnétique) et par transfert de charges entre le métal et la molécule adsorbée (effet chimique). Cette exaltation permet ainsi de détecter spécifiquement des échantillons adsorbés avec des concentrations extrêmement faibles et/ou sur des temps très courts.

Cette exaltation peut se faire grâce à des « points chauds » (« hot spots » en anglais).

Ces points chauds sont des zones du substrat au niveau desquelles le champ électromagnétique est localisé et intense. Pour cela, les points chauds présentent généralement des dimensions inférieures à la longueur d'onde de la lumière monochromatique incidente.

L'art antérieur connait ainsi des procédés permettant de réaliser des points chauds en surface d'un substrat. Ces points chauds peuvent être formés par des cavités ou par des effets de pointe. Ainsi, le document Appl. Phys. Lett. 97, 063106 2010, Nanoletters, 9, 4505, 2009 décrit des points chauds formés par des pointes. Le document Nano Lett. 11 , 2538, 2011 ; J. Vac. Sci. Technol. B 27, 2640 (2009) décrit quant à lui des points chauds formés par des cavités.

Le document MYEONG-LOK SEOL ET AL : "Multi-layer nanogap array for high-performance SERS substrate", NANOTECHNOLOGY, IOP, BRISTOL, GB, vol. 22, no. 23, 11 avril 2011, page 235303, décrit un procédé de fabrication d'un réseau de nanogap multicouches composé de trois nanogaps d'or alignés linéairement pour un substrat de spectroscopie Raman à surface améliorée (SERS). Le processus global pour la structure proposée est simple et fiable avec l'utilisation d'un procédé de fabrication sans photolithographie, qui ne comprend que le dépôt et la gravure. Le dépôt chimique en phase vapeur (CVD) est utilisé pour former un réseau de nanogap uniforme et hautement contrôlable. La largeur de nanogap, un paramètre crucial dans SERS, est déterminée par l'épaisseur du film sacrificiel de CVD. Des expériences sur la largeur du nanogap et la dépendance de l'angle de polarisation sont effectuées pour caractériser le réseau de nanogap multicouche fabriqué comme un substrat SERS.

Toutefois, les méthodes de formation des points chauds de l'art antérieur utilisent des technologies de structuration pouvant atteindre de très hautes résolutions spatiales et elles sont donc complexes et très couteuses. En outre, elles ne permettent généralement pas de produire des substrats présentant une forte densité de points chauds, de sorte que l'augmentation de l'intensité lumineuse émise par les molécules d'intérêt est limitée.

### EXPOSE DE L'INVENTION

L'invention vise à remédier aux inconvénients de l'état de la technique en proposant un procédé de fabrication d'un substrat pour diffusion Raman exaltée de surface qui soit simple à mettre en œuvre, et qui permette une augmentation constante de l'intensité lumineuse émise par les molécules sur l'ensemble du substrat.

Un autre objet de l'invention est de proposer un procédé de fabrication d'un substrat pour diffusion Raman exaltée de surface qui soit reproductible et fiable, qui permette une forte augmentation de l'intensité lumineuse émise par les molécules d'intérêt et qui présente une forte densité de points chauds.

Un autre objet de l'invention est de proposer un procédé de fabrication d'un substrat pour diffusion Raman exaltée de surface qui permette de réaliser simultanément un grand nombre de substrats identiques.

Pour ce faire, un premier aspect de l'invention concerne un procédé de fabrication d'un substrat pour diffusion Raman exaltée de surface adapté pour recevoir une onde incidente à une longueur d'onde incidente, le procédé comportant les étapes suivantes :
- (a) réalisation d'une structure porteuse sur une surface supérieure d'un support, la structure porteuse comportant au moins un motif microstructuré, le motif microstructuré comportant un sommet et des parois latérales, les parois latérales s'étendant suivant une direction sécante à la direction de la surface supérieure;
- (b) dépôt d'une multicouche sur la structure porteuse, la multicouche comportant au moins deux couches d'un premier matériau diélectrique, dites « couches pilier », séparées l'une de l'autre par une couche d'un deuxième matériau diélectrique, dite « couche intercalaire », le deuxième matériau diélectrique pouvant être gravé sélectivement par rapport au premier matériau diélectrique;
- (c) gravure d'une partie de la multicouche déposée sur le sommet du motif microstructuré de façon à exposer une extrémité de chaque couche de la multicouche;
- (d) gravure sélective d'une partie de chaque extrémité de chaque couche intercalaire de façon à former des cavités entre les extrémités de deux couches pilier successives;
- (e) dépôt d'une couche métallique sur chaque extrémité de chaque couche pilier.

Ainsi, ce procédé propose de réaliser dans un premier temps une structure porteuse dont les dimensions, typiquement comprises entre 50 nm et 100 µm, ne permettent pas directement d'obtenir la fonction d'exaltation du champ électromagnétique, mais qui est facile à réaliser par les techniques connues. Sur cette structure porteuse, on réalise ensuite d'autres structures avec des dimensions caractéristiques bien plus faibles qui cette fois permettent d'exalter le champ électromagnétique. Ces secondes structures sont réalisées par dépôts successifs de couches réalisées dans deux matériaux diélectriques différents dont l'un peut être gravé sélectivement par rapport à l'autre de façon à former une multicouche qui épouse la forme de la structure porteuse. On réalise ensuite localement un écrêtage de la partie de la multicouche déposée sur la partie supérieure de chaque motif de la structure porteuse. L'alternance des couches de la multicouche est alors exposée à l'air de sorte que l'on a accès à chacune des extrémités des couches de la multicouche. On peut alors graver sélectivement et partiellement les extrémités des couches intercalaires de la multicouche de façon à former des cavités entre les extrémités de deux couches piliers successives. Le procédé comporte ensuite une étape de dépôt d'une couche métallique sur chacune des extrémités des couches piliers. Cette étape de fonctionnalisation de l'extrémité des couches pilier avec une couche métallique permet de former des points chauds permettant d'exalter le signal Raman émis par les molécules d'intérêt qui seront déposées à la surface du substrat grâce à un effet de couplage électromagnétique entre deux couches métalliques successives. Les couches métalliques déposées sur les extrémités des couches pilier sont également appelées « picots métalliques » dans la suite.

Le procédé est particulièrement avantageux car il permet de réaliser facilement des picots métalliques de dimensions nanométriques séparés par des cavités de dimensions nanométriques sans avoir recourt à des procédés de gravure agressifs. En outre, la largeur des picots métalliques et des cavités est très bien contrôlée puisqu'elle est déterminée par l'épaisseur des couches déposées. Cette épaisseur est facile à contrôler.

Le procédé permet donc d'obtenir facilement un substrat permettant un renforcement du champ électromagnétique. L'intensité du champ électromagnétique obtenu grâce au substrat ainsi formé peut ainsi être entre 10 fois et plusieurs milliers de fois supérieure à celle obtenue avec les substrats de l'art antérieur.

Le procédé selon l'invention peut également présenter une ou plusieurs des caractéristiques ci-après prises individuellement ou selon toutes les combinaisons techniquement possibles, dans le cadre des revendications annexées.

Avantageusement, le procédé comporte en outre une étape de dépôt d'une couche métallique sur chaque extrémité de chaque couche intercalaire. Cette étape permet donc de déposer une couche métallique au fond de chaque cavité formée entre deux picots métalliques successifs puisque le fond de chaque cavité est formé par l'extrémité d'une couche intercalaire. Cette étape permet un renforcement du champ électromagnétique puisqu'il s'établit ainsi non seulement un couplage entre les couches métalliques déposées sur les extrémités de deux couches piliers successives mais également entre une couche métallique déposée sur l'extrémité d'une couche pilier et la couche métallique déposée sur l'extrémité de la couche intercalaire qui lui est adjacente.

Avantageusement, les couches de la multicouche sont déposées suivant une technique de dépôt conforme. Cette technique de dépôt conforme est de préférence un traitement thermique dans un four ultra vide à haute température, également appelée TTH.

Avantageusement, lors de l'étape de dépôt d'une couche métallique sur chaque extrémité de chaque couche pilier, la couche métallique peut être déposée par l'une des techniques suivantes : dépôt physique en phase vapeur (PVD), évaporation sous vide, ou encore par électrolyse.

Avantageusement, chaque motif microstructuré présente une hauteur comprise entre 50 nm et 100 µm, ce qui permet de fabriquer facilement le motif microstructuré avec les procédés connus.

Avantageusement, chaque couche de la multicouche présente une épaisseur comprise entre 1 angström et 100 nm, et de préférence entre 10 nm et 50 nm. L'épaisseur des couches de la multicouche conditionnera la largeur des picots métalliques et celles des cavités entre ces picots.

Avantageusement, la multicouche présente une épaisseur inférieure à la hauteur du motif microstructuré, ce qui permet de mettre à jour toutes les couches lors de l'étape (c) de gravure de la partie de la multicouche déposée sur le sommet des motifs microstructurés.

Avantageusement, les parois latérales du motif microstructuré s'étendent suivant une direction qui forme un angle strictement inférieur à 90° avec une direction normale à la surface supérieure du support, ce qui permet de réaliser plus facilement des dépôts conformes sur le motif microstructuré.

Avantageusement, la structure porteuse est réalisée de façon à former un cristal photonique vis-à-vis d'une onde incidente éclairant le substrat.

Avantageusement, la structure porteuse est réalisée de façon à ce que les parois latérales du motif microstructuré comportent des faces séparées entre elles par des arêtes, l'angle de ces arêtes étant choisi de façon à ce que la structure porteuse, une fois recouverte par la multicouche, génère un renforcement du champ électromagnétique par effet de pointe dans des zones situées à proximité des arêtes. Selon différents modes de réalisation, la gravure d'une partie de la multicouche déposée sur le sommet du motif microstructuré peut être effectuée par polissage mécano-chimique ou par gravure sèche.

Un deuxième aspect de l'invention concerne un substrat pour diffusion Raman exaltée de surface adapté pour recevoir une onde incidente à une longueur d'onde incidente comportant :
- un support comportant une surface supérieure;
- une structure porteuse disposée sur la surface supérieure du support, la structure porteuse comportant au moins un motif microstructuré, le motif microstructuré comportant un sommet et des parois latérales, les parois latérales s'étendant suivant une direction sécante à la direction de la surface supérieure ;
- une multicouche disposée sur les parois latérales du motif microstructuré, la multicouche comportant au moins deux couches d'un premier matériau diélectrique, dites « couches pilier », séparées l'une de l'autre par une couche d'un deuxième matériau diélectrique, dite « couche intercalaire », le deuxième matériau diélectrique pouvant être gravé sélectivement par rapport au premier matériau diélectrique, chaque couche intercalaire présentant une extrémité en retrait par rapport à une extrémité de chaque couche pilier adjacente de sorte que les extrémités de deux couches pilier successives forment des picots séparés par une cavité, les extrémités des couches pilier étant recouvertes par une couche métallique,
la structure porteuse:
- étant dimensionnée de façon à former un cristal photonique vis-à-vis d'une onde incidente éclairant le substrat et/ou
- étant telle que les parois latérales du motif microstructuré comportent des faces séparées entre elles par des arêtes, l'angle de ces arêtes étant choisi de façon à ce que la structure porteuse, une fois recouverte par la multicouche, génère un renforcement du champ électromagnétique par effet de pointe dans des zones situées à proximité des arêtes.

Un tel substrat comporte de multiples points chauds entre couches métalliques successives au niveau desquelles se forment un couplage électromagnétique, ce qui permet d'exalter fortement le signal Raman émis par les molécules d'intérêt déposées sur ce substrat grâce à l'excitation de plasmons localisés du métal (exaltation par effet électromagnétique). Un tel substrat permet donc d'augmenter l'intensité lumineuse émise par des molécules d'intérêt qui sont déposées à sa surface de sorte qu'il permet une détection plus rapide de ces molécules d'intérêt.

Le substrat selon le deuxième aspect de l'invention peut présenter une ou plusieurs des caractéristiques ci-après prises individuellement ou selon toutes les combinaisons techniquement possibles, dans le cadre des revendications annexées.

Avantageusement, la paroi latérale du motif microstructuré comporte des faces séparées par des arêtes, ce qui permet de créer un renforcement du champ électromagnétique par effet de pointe et donc d'augmenter l'exaltation du signal Raman émis par les molécules.

Avantageusement, la structure porteuse comporte plusieurs motifs microstructurés formant un réseau périodique, ce qui permet d'augmenter la densité de points chauds à la surface du substrat, et d'homogénéiser leur répartition sur le substrat. L'exaltation du signal Raman générée par le substrat est ainsi plus importante et plus homogène. Avantageusement, l'extrémité de chaque couche intercalaire est également recouverte d'une couche métallique ce qui permet d'augmenter le couplage électromagnétique créé et donc l'augmentation de l'intensité lumineuse émise par des molécules d'intérêt qui sont déposées à sa surface de sorte qu'il permet une détection plus rapide de ces molécules d'intérêt.

Avantageusement, la couche métallique déposée sur l'extrémité d'une couche intercalaire est disjointe la couche métallique déposée sur l'extrémité de la couche pilier adjacente à cette couche intercalaire ce qui permet de diminuer la réflectivité du substrat ainsi formé et donc ce qui permet de piéger la lumière en formant une cavité de type Pérot Fabry et ainsi d'augmenter l'exaltation par effet électromagnétique obtenue.

Avantageusement, la couche métallique déposée sur l'extrémité d'une couche intercalaire est séparée de la couche métallique déposée sur l'extrémité de la couche pilier adjacente à cette couche intercalaire d'une distance comprise entre 1 nm et 40 nm, et préférence entre 10 nm et 30 nm, ce qui permet une augmentation optimale de l'exaltation par effet électromagnétique obtenue.

Selon un mode de réalisation préférentiel, la structure porteuse est dimensionnée de façon à former un cristal photonique vis-à-vis d'une onde incidente éclairant ce substrat. Le cristal photonique permet donc de rediriger la lumière incidente dans une direction parallèle au plan du substrat. Ainsi, lorsque l'onde incidente arrive sur le substrat, elle va etre couplée dans le plan du substrat, de sorte qu'on augmente ainsi encore l'intensité lumineuse émise par des molécules d'intérêt qui sont déposées à sa surface. Ce substrat permet donc d'augmenter encore la rapidité de détection des molécules d'intérêt.

Selon un mode de réalisation préférentiel, la structure porteuse est dimensionnée de façon à former un guide d'onde agencé pour faciliter l'extraction d'un signal Raman émis par des molécules déposées à la surface du substrat.

Avantageusement, chaque motif microstructuré présente une hauteur comprise entre 50 nm et 100 µm.

Avantageusement, chaque couche de la multicouche présente une épaisseur comprise entre 1 angström et 50 nm, de préférence entre 10 nm et 50 nm.

Avantageusement, chaque cavité présente une profondeur comprise entre 1 angström et 200 nm, et de préférence entre 10 nm et 100 nm.

### BREVES DESCRIPTION DES FIGURES

D'autres caractéristiques et avantages de l'invention ressortiront à la lecture de la description détaillée qui suit, en référence aux figures annexées, qui représentent :
- Les figures 1a à 1g, les étapes d'un procédé selon un mode de réalisation de l'invention ;
- Les figures 1c', 1d' et 1e', des étapes alternatives aux étapes représentées respectivement sur les figures 1c, 1d, 1e ;
- Les figures 2a et 2b, des structures porteuses pouvant être utilisées dans un procédé selon un mode de réalisation de l'invention ;
- La figure 3a, une représentation schématique d'un substrat selon un mode de réalisation de l'invention ;
- La figure 3b, une vue agrandie de la partie E du substrat de la figure 3a ;
- La figure 4a, une courbe représentant l'évolution de la réflectivité en fonction de la longueur d'onde de la lumière incidente sur un substrat selon un mode de réalisation de l'invention comportant des picots métalliques d'une largeur W1=40 nm et d'une épaisseur H1=30 nm, deux picots métalliques étant séparés par une couche intercalaire d'une largeur W2=15 nm et d'une hauteur H2=45 nm, les picots métalliques étant déposés sur une couche pilier d'une hauteur H3=145 nm ;
- Les figures 4b et 4c, le champ électromagnétique sur le substrat de la figure 4a, calculé respectivement à 514 nm et à 785 nm ;
- La figure 5, une courbe représentant la réflectivité d'un premier substrat A et d'un deuxième substrat B selon deux modes de réalisation de l'invention, pour une longueur d'onde incidente de 785 nm, en fonction de la hauteur H1 des picots métalliques de ces substrats, lorsque ces substrats ont des dimensions suivantes : W1=40 nm, W2=15 nm, H2=45 nm, H3=145 nm;
- La figure 6, un diagramme représentant l'évolution de la réflectivité d'un substrat selon un mode de réalisation de l'invention pour une longueur d'onde incidente de 785 nm, en fonction des dimensions H2 et H3 de ce substrat avec W1 fixée à 40 nm, W2 fixée à 15 nm, H1 fixée à 30 nm ;
- La figure 7a, une vue en coupe schématique d'un substrat selon un mode de réalisation de l'invention comportant une couche métallique sur l'extrémité des couches pilier;
- La figure 8a, une représentation du niveau de réflectivité en fonction de la période de la structure porteuse et de la longueur d'onde incidente pour w1, w2 et h1 sur le substrat de la figure 7a ;

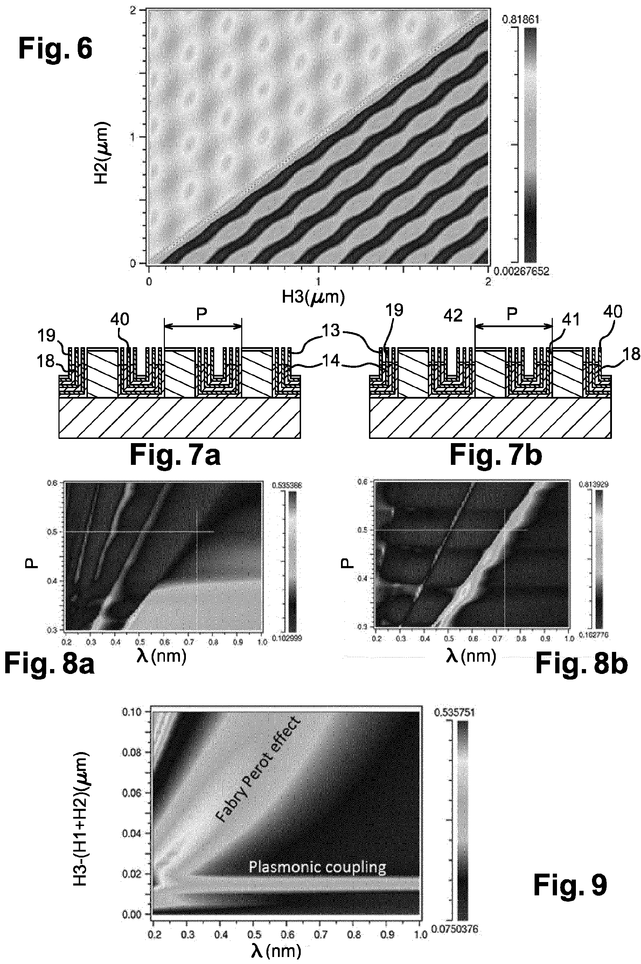

- La figure 7b, une vue en coupe schématique d'un substrat selon un autre mode de réalisation de l'invention comportant une couche métallique sur l'extrémité des couches pilier et une couche métallique sur l'extrémité des couches intercalaires ;
- La figure 8b, une représentation du niveau de réflectivité en fonction de la période de la structure porteuse et de la longueur d'onde incidente pour w1, w2 et h1 sur le substrat de la figure 7b ;
- La figure 9, une cartographie du couplage de la pompe Raman en fonction de la longueur d'onde et de la distance entre la couche métallique déposée sur l'extrémité des couches pilier, et celle déposée sur l'extrémité des couches intercalaires ;

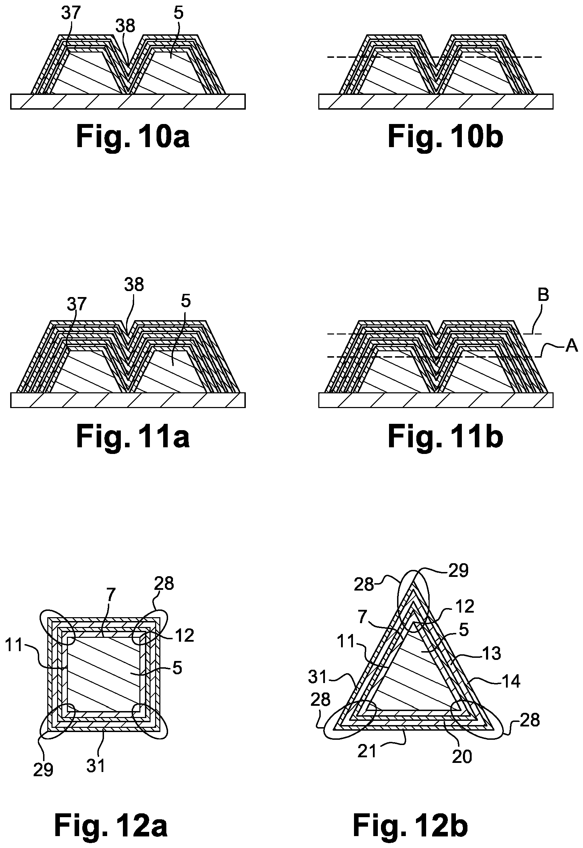

- Les figures 10a et 10b, des vues d'un substrat selon un mode de réalisation de l'invention pendant un procédé de réalisation de ce substrat ;
- Les figures 11a et 11b, des vues d'un substrat selon un autre mode de réalisation pendant un procédé de réalisation de ce substrat;
- Les figures 12a et 12b, des vues de dessus de substrats selon deux modes de réalisation de l'invention ;

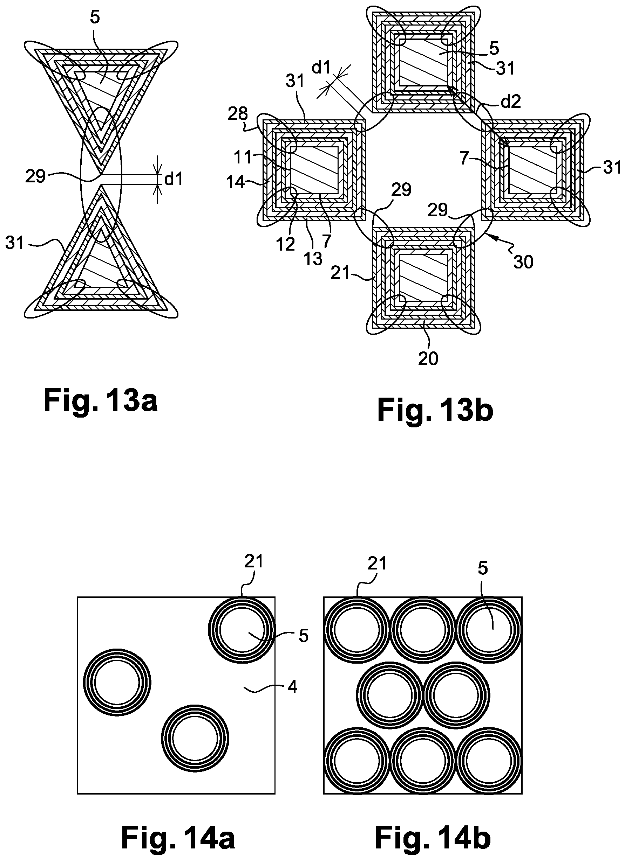

- Les figures 13a et 13b, des vues de dessus de substrats selon deux autres mode de réalisation de l'invention ;
- Les figures 14a et 14b, des vues de dessus de substrats selon un premier et un second modes de réalisation de l'invention ;

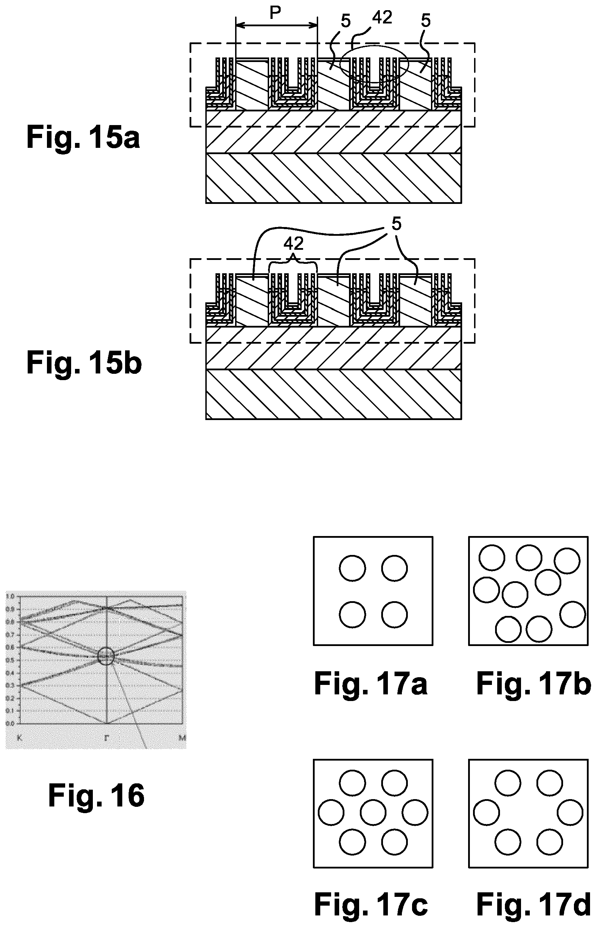

- La figure 15a, une vue de côté d'un substrat selon un mode de réalisation de l'invention formant un guide d'onde pour le signal Raman émis par les molécules d'intérêt déposées sur ledit substrat ;
- La figure 15b, une vue de côté d'un substrat selon un mode de réalisation de l'invention formant un réseau d'extraction pour le signal Raman émis par les molécules d'intérêt déposées sur ledit substrat ;
- La figure 16 un diagramme de bandes d'un cristal photonique formé par le substrat de la figure 13b, ce diagramme étant calculé par une méthode dans le domaine fréquentielle à base d'onde plane (ou « plane wave-basis frequency-domain method » en anglais) ;
- Les figures 17a à 17d, des exemples de géométries de cristaux photoniques pouvant être utilisées dans le cadre de l'invention.

### DESCRIPTION DETAILLEE D'AU MOINS UN MODE DE REALISATION

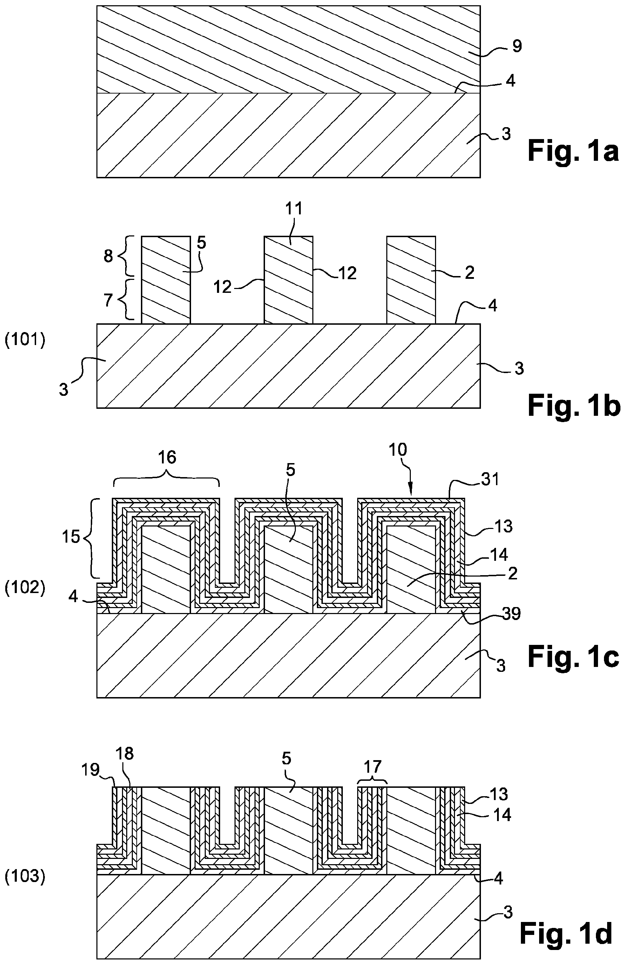

Les figures 1a à 1g représentent les différentes étapes d'un procédé selon un mode de réalisation de l'invention.

Ce procédé comporte une première étape 101 de réalisation d'une structure porteuse 2 sur une surface supérieure 4 d'un support 3. Selon différents modes de réalisation, le support 3 peut être en silicium, métal, verre. Par ailleurs, la surface supérieure 4 peut être recouverte par une couche d'oxyde de silicium.

La structure porteuse 2 comporte au moins un motif microstructuré 5, et de préférence plusieurs motifs microstructurés 5. Chaque motif microstructuré présente de préférence des dimensions comprises entre 50 nm et 100 µm. Chaque motif microstructuré 5 présente une partie supérieure 8, également appelé « sommet » ou « crête », et une paroi latérale 7, également appelée « flanc ». La paroi latérale 7 des motifs microstructurés 5 s'étend de préférence suivant une direction sécante à la surface supérieure 4 du support 3. Les motifs microstructurés 5 peuvent présenter différentes formes.

Ainsi, selon un mode de réalisation représenté sur la figure 1b, chaque motif microstructuré 5 peut présenter une forme de parallélépipède. Dans ce cas, chaque motif microstructuré 5 comporte :
- une paroi supérieure 8 s'étendant suivant une direction sensiblement parallèle à la surface supérieure 4 du support ;
- une paroi latérale 7 s'étendant suivant une direction sensiblement perpendiculaire à la surface supérieure 4 du support 3. La paroi latérale 7 comporte quatre faces 11 séparées entre elles par des arêtes 12.

Toutefois, les motifs microstructurés pourraient également présenter d'autres formes.

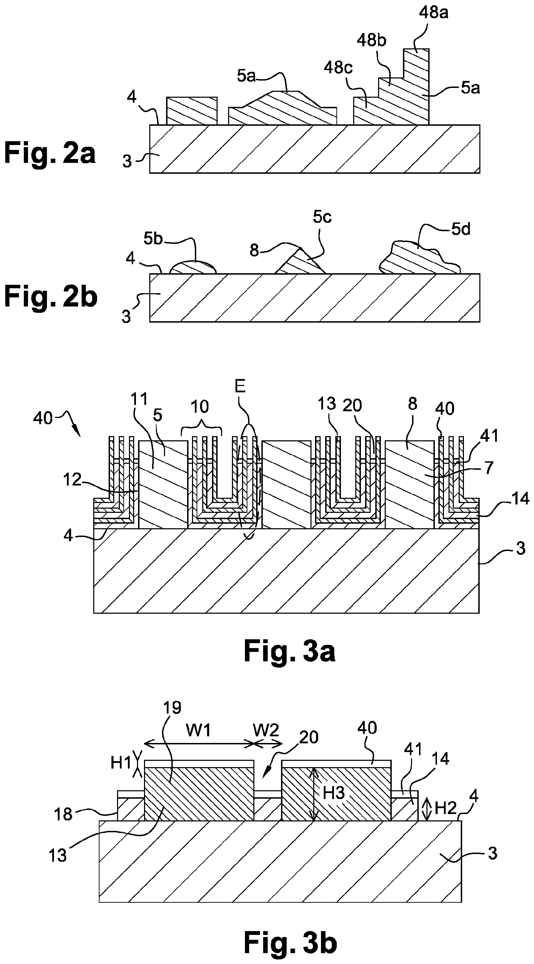

Ainsi en référence à la figure 2a, chaque motif microstructuré 5a pourrait comporter plusieurs parties 48a, 48b, 48c, présentant des hauteurs différentes les unes des autres. On obtient alors un motif microstructuré 5a qui présente une forme d'escalier. En référence à la figure 2b, chaque motif microstructuré 5b pourrait présenter une forme de dôme, ou encore une forme de triangle, de pyramide, ou encore des formes plus complexes. Selon différents modes de réalisation, les motifs microstructurés de la structure porteuse peuvent tous présenter la même forme, comme représenté sur la figure 1b, ou alors ils peuvent présenter des formes différentes, comme représenté sur les figures 2a et 2b.

La structure porteuse 2 est de préférence constituée d'un matériau diélectrique. Elle peut par exemple être constituée de nitrure de silicium ou oxyde de silicium. Selon un mode de réalisation préférentiel, la structure porteuse est constituée de polymères. En effet, les polymères présentent l'avantage de ne pas ou très peu absorber la résonance plasmonique des métaux, de sorte qu'ils ne diminueront pas l'exaltation du champ électromagnétique local. Selon différents modes de réalisation, la structure porteuse peut être constituée de polymères à base acrylique, de polymères à base de poly hydroxy styrène (PHS) ou de polymères à base de méthyl méthacrylate (MMA). Les polymères à base acrylique permettent d'avoir une meilleure tenue mécanique pour les étapes ultérieures du procédé.

La structure porteuse 2 peut être réalisée grâce à différentes techniques en fonction du matériau qui la constitue. Ainsi, en référence aux figures 1a et 1b, lorsque la structure porteuse est réalisée en polymère, l'étape de réalisation de la structure porteuse peut comporter les sous-étapes suivantes :
- formation d'une couche de polymère 9 sur la surface supérieure 4 du support 3, par exemple par dépôt à la tournette (ou « spin-coating » en anglais) ;
- formation des motifs microstructurés 5, par exemple par lithographie nanoimpression (ou « nanoimprint lithography » en anglais), photolithographie, lithographie électronique, lithographie dans l'extrême ultraviolet, lithographie interférentielle ou encore par écriture laser.

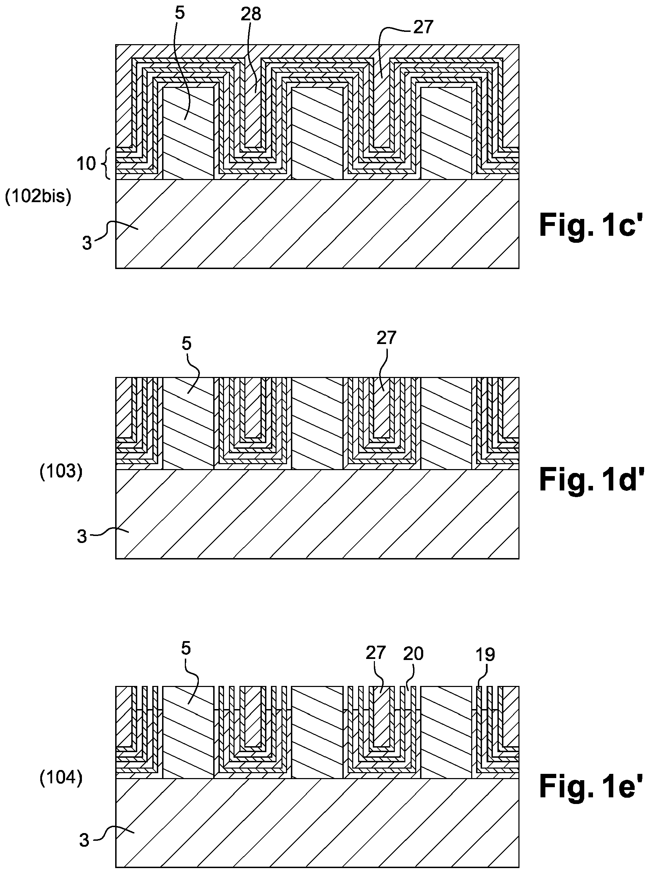

En référence à la figure 1c, le procédé comporte ensuite une étape 102 de dépôt d'une multicouche 10 sur la structure porteuse 2. La multicouche 10 épouse la forme de la structure porteuse 2 de sorte qu'elle se dépose sur la partie supérieure 8 des motifs microstructurés 5 et sur leur paroi latérale 7. La multicouche 10 comporte donc des parties 15 qui s'étendent suivant une direction sécante à la surface supérieure 4 du support et d'autres parties 16 qui s'étendent suivant une direction sensiblement parallèle à la surface supérieure 4 du substrat.

La multicouche 10 comporte au moins deux couches 13 d'un premier matériau diélectrique. Les couches 13 du premier matériau diélectriques sont appelées « couches pilier» 13. Deux couches pilier 13 successives sont séparées l'une de l'autre par une couche intercalaire 14 en un deuxième matériau diélectrique. Le deuxième matériau diélectrique est choisi de façon à pouvoir être gravé sélectivement par rapport au premier matériau diélectrique. Par ailleurs, le premier et le deuxième matériaux diélectriques sont choisis de façon à ce qu'ils n'absorbent pas ou peu le plasmon généré par le substrat. Le premier et le deuxième matériaux diélectriques sont de préférence choisis parmi les matériaux suivants : oxyde de silicium, alumine, oxyde d'hafnium, nitrure de silicium, oxyde de titane.

Chaque couche 13, 14 de la multicouche présente de préférence une épaisseur comprise entre 1 nm et 100 nm.

Les couches de la multicouche sont de préférence déposées par une méthode de dépôt conforme de sorte que l'épaisseur de la multicouche est sensiblement la même sur toute la surface de chaque motif microstructuré. On peut pour cela par exemple utiliser un dépôt thermique sous ultra vide et à haute température, un dépôt EVAP, ou encore un dépôt par pulvérisation avec cible inclinée et substrat rotatif.

Lors de l'étape de dépôt de la multicouche, la première couche déposée sur les motifs microstructurés, qui sera appelée « couche intérieure » 39, peut être une couche pilier ou alors ce peut être une couche intercalaire. De même, la dernière couche déposée, qui sera appelée « couche extérieure » 31, peut être une couche pilier ou alors ce peut être une couche intercalaire.

En référence à la figure 1d, le procédé comporte ensuite une étape 103 de gravure d'une partie 16 de la multicouche déposée sur la partie supérieure 8 de chaque motif microstructuré 5. Cette étape 103 est dite «étape d'écrêtage ». En effet, elle comporte une étape de gravure de la partie 16 de la multicouche déposée sur la crête 8 de chacun des motifs microstructurés 5. Cette étape 103 peut également comporter une étape de gravure d'une partie de la crête 8 de chaque motif microstructuré 5. Dans le mode de réalisation de la figure 1d, la partie 16 des multicouches déposée sur la surface supérieure 8 des motifs microstructurés 5 est gravée. Pour cela, on peut par exemple graver les régions de la multicouches qui sont parallèles à la surface supérieure 4 du support, tout en gravant moins vite les régions 15 de la multicouche qui sont inclinées par rapport à la surface supérieure 4 du support. On peut pour cela utiliser une technique de gravure espaceur (ou « spacer patterning » en anglais). Cette étape de gravure 103 peut également être réalisée par polissage mécano chimique (ou CMP pour « Chemical Mechanical Planarization »).

On obtient alors à l'issue de cette étape 103 des colonnes 17 s'étendant suivant une direction sécante à la surface supérieure 4 du support 3, chaque colonne 17 comportant une alternance de couches pilier 13 et de couches intercalaires 14. Les extrémités supérieures 18 de chaque couche pilier 13 et les extrémités supérieures 19 de chaque couche intercalaire 14 sont exposées à l'air et elles sont donc accessibles pour la suite des étapes du procédé.

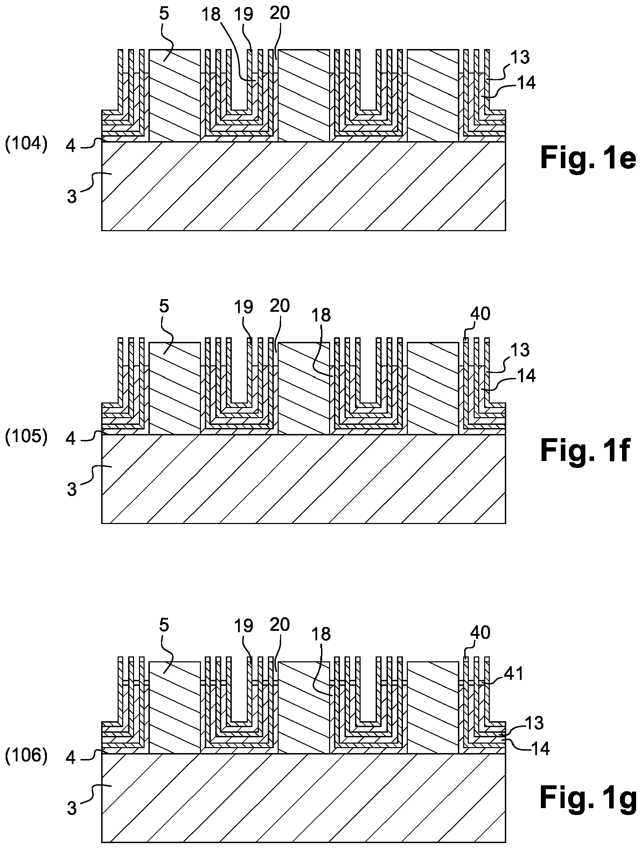

En référence à la figure 1e, le procédé comporte ensuite une étape 104 de gravure sélective d'une partie des extrémités 18 des couches intercalaires 14 de façon à former des cavités d'air 20 entre les extrémités 19 de deux couches pilier 13 successives. Plus précisément, au cours de cette étape, les extrémités 18 des couches intercalaires 14 sont gravées sélectivement par rapport aux extrémités 19 des couches pilier 13 de façon à ce que, à la fin de cette étape, les extrémités 19 des couches métalliques soient séparées par des cavités d'air 20. Cette étape de gravure est partielle de façon à conserver une partie des couches intercalaires 14 entre les couches pilier 13, ce qui permet de maintenir les couches pilier 13 en place sans qu'elles ne s'effondrent les unes sur les autres et aussi d'avoir des cavités d'air 20 de profondeur contrôlée. La technique utilisée pour graver sélectivement les couches intercalaires dépend du matériau choisi pour les couches intercalaires 14 et pour les couches pilier 13. Selon différents modes de réalisation, la technique choisie peut être une technique de gravure sèche ou humide.

En référence à la figure 1f, le procédé comporte ensuite une étape 105 de dépôt d'une couche métallique 40 sur chaque extrémité 19 de chaque couche pilier 13. Cette couche métallique peut être par exemple être en or, en argent, en cuivre en aluminium, cuivre ou en alliage de ces matériaux. La couche métallique pourrait égalemet être constituée de Ni, Ti, TiN ou en alliage de ces matériaux.Cette étape de dépôt peut être réalisée par une technique de dépôt physique en phase vapeur, évaporation, ou encore par électrolyse. Ces couches métalliques 40 déposées sur les extrémités 19 des couches pilier 13 sont également appelées « picots métalliques ». Les couches métalliques 40 permettent un renforcement localisé du champ électromagnétique quand elles sont soumises à une radiation électromagnétique incidente d'une longueur d'onde prédéfinie.

Le procédé permet de fabriquer un substrat grâce auquel l'intensité lumineuse émise par des molécules d'intérêt qui sont déposées à sa surface est amplifiée. Le substrat ainsi formé permet donc une détection plus rapide des molécules d'intérêt qui sont déposées à sa surface.

En référence à la figure 1g, le procédé peut également comporter une étape 106 de dépôt d'une couche métallique 41 sur l'extrémité 18 des couches intercalaires 14. Cette couche métallique 41 est de préférence constituée du même matériau que celui qui constitue la couche métallique 40 déposée sur les extrémités 19 des couches piliers. Les couches métalliques 41 déposées sur les couches intercalaires présentent de préférence la même épaisseur que les couches métalliques 40 déposées sur les couches pilier.

A l'issue de cette étape, on obtient donc des couches métalliques 40 à la fois sur les extrémités des couches piliers et au fond des cavités qui séparent les extrémités 19 de deux couches piliers successives. Les couches métalliques 41 déposées sur les extrémités des couches intercalaires sont de préférence disjointes des couches métalliques 40 déposées sur les extrémités des couches piliers afin d'optimiser le renforcement du champ électromagnétique comme on le verra dans la suite. L'étape 106 de dépôt des couches métalliques 41 sur les couches intercalaires est de préférence simultanée à l'étape 105 de dépôt des couches métalliques 40 sur les couches pilier.

Le procédé peut ensuite comporter une étape de dépôt de molécules d'intérêt à la surface du substrat ainsi obtenu. Les molécules d'intérêt se déposent alors à la surface des picots métalliques et dans les cavités d'air. Les matériaux choisis pour réaliser la structure porteuse peuvent être choisis en fonction de leur énergie de surface, de façon à contrôler le dépôt des molécules qui seront ensuite déposées sur le substrat. On peut ainsi favoriser le dépôt des molécules à certains endroits du substrat plutôt qu'à d'autres endroits.

L'invention n'est pas limitée au mode de réalisation décrit ci-dessus. Ainsi, comme représenté sur les figures 1c' à 1e', le procédé décrit en référence aux figures 1a à 1f pourrait également comporter, suite à l'étape 102 de dépôt de la multicouche 10, une étape additionnelle 102bis de dépôt d'un matériau diélectrique 27 dans les espaces 28 formés entre les motifs microstructurés 5 recouverts par la multicouche 10. Ce matériau diélectrique 27 permet de remplir l'espace vide 28 entre les motifs microstructurés 5 ce qui rend plus aisée et plus contrôlable l'étape 103 d'écrêtage. Par ailleurs, comme cet espace vide 28 est rempli, les résidus formés pendant l'étape 103 d'écrêtage ne vont pas se loger dans l'espace vide 28 de sorte qu'ils pourront être par la suite aisément retirés par des procédés de nettoyage de la surface. Dans le cas contraire le retrait de ces résidus peut s'avérer impossible ou très compliqué et ces derniers pourraient perturber le bon fonctionnement du substrat. Le matériau diélectrique 27 déposé dans les espaces 28 peut être par exemple de l'oxyde de silicium ou du nitrure de silicium. Les étapes ultérieures 103 à 106 du procédé sont identiques à celles décrites précédemment.

Le procédé selon l'invention est particulièrement avantageux puisqu'il permet d'obtenir des picots métalliques 40 séparés par des cavités de dimensions précisément contrôlables. En effet, la largeur w1 des picots métalliques 40 obtenus est contrôlée en contrôlant l'épaisseur des couches métalliques 13 déposées. De même, la largeur w2 des cavités d'air est contrôlée en contrôlant l'épaisseur des couches intercalaires 14 déposées. La largeur des picots et des cavités et donc facilement et précisément contrôlable puisque l'épaisseur des couches déposées l'est aussi. Par ailleurs, la profondeur des cavités d'air est contrôlable en contrôlant la gravure de l'extrémité des couches intercalaires 20 qui elle aussi est facilement contrôlable. En outre, puisque la couche intercalaire est en matériau diélectrique, le procédé n'utilise pas d'étape de gravure agressive puisque ladite couche intercalaire peut être facilement gravée par gravure sèche ou chimique.

### Dimensionnement des picots métalliques et des cavités:

Un procédé de dimensionnement des couches métalliques 40 déposées sur les couches piliers et des couches métalliques 41 déposées sur les couches intercalaires va maintenant être décrit en référence aux figures 3a, 3b, 4, 5 et 6.

En référence à la figure 3b, chaque couche pilier 13 présente une épaisseur w1 et une hauteur H3. Chaque couche intercalaire 14 présente une épaisseur w2 et une hauteur H2. L'extrémité de chaque couche pilier et l'extrémité de chaque couche intercalaire sont recouvertes d'une couche métallique 40, respectivement 41, d'une épaisseur H1. La distance entre la couche métallique 40 déposée sur une couche pilier et la couche métallique 41 déposée sur la couche intercalaire adjacente à cette couche pilier est donnée par H3-(H1+H2).

Les dimensions w1, w2, H1, H2 et H3 sont choisies de façon à minimiser la réflectivité du substrat pour une longueur d'onde incidente donnée et de maximiser le renforcement du champ électromagnétique.

Pour cela, on choisit tout d'abord la longueur d'onde incidente de la lumière monochromatique qui sera envoyée sur les molécules à détecter. Cette longueur d'onde incidente peut être choisie en fonction des molécules à détecter et/ou en fonction du matériel à la disposition de l'utilisateur. Dans ce mode de réalisation, on choisit par exemple une longueur d'onde incidente de 785 nm.

On choisit ensuite les matériaux qui vont constitués les couches pilier 13 et les couches intercalaires 14. Ce choix peut être dicté par des motivations technologiques, notamment par les procédés disponibles pour déposer ces couches, et par les procédés disponibles pour graver sélectivement le matériau constituant les couches intercalaires par rapport aux couches pilier. Ce choix peut également être réalisé en fonction des affinités chimiques des matériaux avec les molécules à détecter, et/ou en fonction des propriétés d'absorption des matériaux choisis vis-à-vis de la longueur d'onde incidente. Dans ce mode de réalisation, on choisit par exemple de réaliser les couches pilier en Si₃N₄ et les couches intercalaires en SiO₂.

On choisit ensuite les matériaux qui vont constituer les couches métalliques 40 et les couches métalliques 41. Ces matériaux peuvent être choisis en fonction des procédés de dépôt disponibles, et/ou pour des raisons d'affinités chimiques avec les molécules à détecter, et/ou en fonction des propriétés d'absorption de ces matériaux vis-à-vis de la longueur d'onde incidente. Dans ce mode de réalisation, on choisit par exemple de réaliser des couches métalliques 40 et 41 en or.

On effectue ensuite des simulations de façon à déterminer les dimensions w1, w2, H1, H2 et H3 qui minimisent la réflectivité du substrat et maximisent le champ électromagnétique localement.

On peut pour cela utiliser une méthode dite « d'analyse rigoureuse des ondes couplées » (ou RCWA pour « rigourous coupled wave analysis) ou une méthode dite de « domaine temporel des différences finies » (ou FDTD pour « finite différence time domain »). Ces méthodes permettent de simuler la réflectivité d'une surface en fonction de sa géométrie et de sa composition.

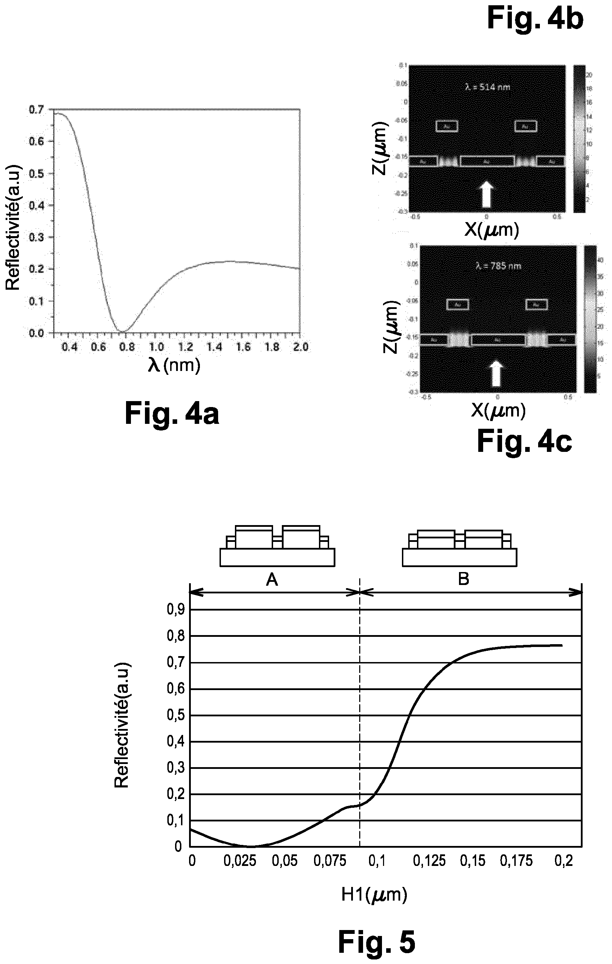

Ainsi, la figure 4a représente l'évolution de la réflectivité du substrat des figures 3a et 3b en fonction de la longueur d'onde incidente. Le substrat présente les dimensions suivantes : w1 = 40 nm; w2 = 15 nm; H1 = 30 nm; H2 = 45 nm ; H3 = 145 nm. La figure 4b représente le champ électromagnétique calculé sur ce substrat en réponse à une onde incidente d'une longueur d'onde de 514 nm. La figure 4c représente le champ électromagnétique maximal calculé sur ce substrat en réponse à une onde incidente d'une longueur d'onde de 785 nm.

En référence à la figure 5, on voit que l'épaisseur H1 des couches métalliques 40 et 41, et la distance H3-H1 -H2 entre ces couches métalliques 40, 41, joue également un rôle dans l'amélioration du champ électromagnétique local. En effet, la figure 5 représente la réflectivité d'un substrat A et d'un substrat B en fonction de l'épaisseur H1 des couches métalliques 40 et 41, pour une onde incidente d'une longueur d'onde de 785 nm. Le substrat A est tel que celui représenté sur les figures 3a et 3b et il présente:
- des couches métalliques 40 et 41 adjacentes qui sont disjointes ;
- des dimensions w1=40 nm, w2=15 nm, H2=45 nm, H3=145 nm.
Le substrat B est identique au substrat A sauf que les couches métalliques 40 et 41 ne sont pas disjointes, c'est-à-dire qu'une couche métallique 40 touche la couche métallique 41 qui lui est adjacente.

Comme on peut le voir sur la figure 5, il est préférable d'avoir des couches métalliques 40 et 41 disjointes de façon à avoir un minimum de réflectivité et un maximum de champ électromagnétique localement. En outre, la réflectivité est minimum pour une épaisseur H1 des couches métalliques 40 et 41 égale à 0.03 µm.

La figure 6 représente l'évolution de la réflectivité pour un substrat semblable à celui de la figure 3b en fonction de H2 et de H3 en présence d'une onde incidente à 785 nm, lorsque w1=40 nm, w2=15 nm, H1=30 nm. Comme on peut le voir sur cette figure, des changements de résonnance important ont lieu en fonction de H2 et de H3.

Ces simulations permettent donc de déterminer :
- l'épaisseur w1 des couches pilier déposées ;
- la largeur w2 des couches intercalaires déposées;
- l'épaisseur H1 des couches métalliques déposées ;
- la hauteur H3 des couches pilier déposées ;
- la hauteur H2 des couches intercalaires déposées.

Par ailleurs, en fonction de l'anisotropie de la technique de dépôt, l'épaisseur w1, w2 des couches pilier et intercalaires déposées pourra être ajustée de façon à compenser cette anisotropie de dépôt. En effet connaissant cette anisotropie de dépôt, on pourra calculer la correction à effectuer aux épaisseurs w1 et w2 de façon à optimiser la forme du substrat final obtenu.

Des simulations peuvent également être effectuées pour déterminer le nombre de couches dans la multicouche. Ces simulations sont identiques à celles présentées précédemment sauf qu'au lieu de ne prendre en considération que deux couches pilier et une couche intercalaire, on prend en considération un plus grand nombre de couches de façon à identifier ou non des modes de couplages entre les différentes répétitions de couches, ce qui pourrait ou non modifier un peu les géométries optimales. On en déduit ainsi l'épaisseur optimale de la multicouche 10.

On peut également choisir de déposer des couches métalliques 40 uniquement sur les couches pilier 13 comme représenté sur la figure 7a, ou alors on peut choisir de déposer des couches métalliques 40 et 41 à la fois sur les couches pilier 13 et sur les couches intercalaires 14 comme représenté sur la figure 7b. La figure 8a représente une cartographie de la réflectivité du substrat de la figure 7a en fonction de la longueur d'onde de l'onde incidente et de la période P de la structure porteuse. Les minimums de réflectivité correspondent aux maximums d'exaltation du champ électromagnétique sur la structure porteuse. La figure 8b représente une cartographie de la réflectivité du substrat de la figure 7b en fonction de la longueur d'onde de l'onde incidente et de la période P de la structure porteuse. Comme on peut le voir sur ces figures, la présence d'une couche métallique à la fois sur l'extrémité des couches pilier et sur l'extrémité des couches intercalaire permet d'améliorer fortement le champ électromagnétique à la longueur d'onde incidente pour laquelle le substrat a été dimensionné.

En référence aux figures 7b et 8b, il est avantageux de réaliser une cavité optique résonnante 42 formée par la couche métallique 40 déposée sur l'extrémité des couches pilier 13 et par la couche métallique 41 déposée sur l'extrémité des couches intercalaires 14. La présence de cette cavité 42 augmente fortement le couplage de la pompe Raman dans le substrat.

Comme on peut le voir sur la figure 9, la force de couplage de la pompe Raman dépend de la distance H3-(H1+H2) entre la couche métallique 40 déposée sur les couches pilier et la couche métallique 41 déposée sur les couches intercalaires. Lorsque cette distance H3-(H1+H2) est égale à 20 nm, on constate que l'on obtient un fort couplage de la pompe Raman dans le substrat. Plus la distance H3-(H1+H2) augmente, moins le couplage est fort. Il est donc avantageux d'avoir une distance H3-(H1+H2) entre la couche métallique 40 déposée sur une couche pilier et la couche métallique 41 déposée sur la couche intercalaire adjacente inférieure à 40 nm, et de préférence à 30 nm, tout en gardant la couche métallique 40 déposée sur une couche pilier disjointe de la couche métallique 41 déposée sur la couche intercalaire adjacente.

### Dimensionnement des motifs microstructurés :

En référence aux figures 10a, 10b, 11a, 11b, le procédé comporte une étape de détermination des dimensions des motifs microstructurés de la structure porteuse. Le choix de ces dimensions ne nécessite pas obligatoirement un calcul de renforcement des ondes électromagnétiques, en dehors de la hauteur de ces motifs qui est déterminée de façon à avoir la hauteur H3 voulue pour les couches pilier. Les autres dimensions des motifs microstructurés sont de préférence déterminées en fonction de
- la capacité technologique des procédés utilisés pour réaliser ces motifs lors de l'étape 101;
- la capacité technologique des procédés de gravure utilisés lors de l'étape 103 ;
- la capacité technologique des procédés de dépôt pour leur aptitude à planariser une structure existante si l'épaisseur déposée est trop importante. En effet, si les motifs microstructurés sont trop hauts, il est plus compliqué d'avoir un dépôt conforme sur toute la hauteur de chaque motif car chaque étape de dépôt, notamment si elle est réalisée par PVD ou évaporation, n'est pas parfaitement conforme et il y a une légère déformation de la forme de la structure résultante après chaque dépôt et donc au fur et à mesure du dépôt il peut y avoir une planarisation de la structure ce qui n'est pas recherché.

Par ailleurs, en référence aux figures 10a et 10b, la hauteur des motifs microstructurés 5 est de préférence choisie de telle sorte qu'après dépôt de la multicouche le point le plus haut 37 de la première couche déposée sera plus haut que le point le plus bas 38 de la dernière couche déposée. Ainsi, après l'étape 103 d'écrêtage, toutes les couches de la multicouche seront mises à jour. Dans le cas contraire, représenté sur les figures 11a et 11b, une partie des couches de la multicouche ne sera pas utilisable pour la fabrication des cavités, puisque :
- soit elles seront complètement supprimées lors de l'étape d'écrêtage. C'est le cas si l'écrêtage se fait suivant la ligne A ;
- soit elles ne seront pas du tout utilisées car complètement recouvertes par d'autres couches. C'est le cas si l'écrêtage se fait suivant la ligne B.

La forme de chaque motif microstructuré 5 peut également être déterminée en simulant la réponse qu'aura le substrat en fonction de la forme choisie. Ces simulations peuvent également être effectuées avec une méthode d'analyse rigoureuse des ondes couplées ou une méthode de domaine temporel des différences finies. Ainsi, en référence aux figures 12a, 12b, 13a, 13b, la forme des parois latérales 7 des motifs microstructurés 5 est de préférence choisie de façon à ce que les parois latérales 7 comportent des faces 11 séparées entre elles par des arêtes 12. L'angle de ces arêtes 12 est déterminé de façon à ce que la structure porteuse, une fois recouverte par la multicouche 10, génère un renforcement du champ électromagnétique par effet de pointe dans des zones 28 situées à proximité des arêtes 12. En effet, ce sont alors les couches métalliques déposées sur les arêtes 12 qui vont générer un effet de pointe.

Par ailleurs, en référence aux figures 13a et 13b, l'écartement entre deux motifs microstructurés adjacents peut également être déterminé, par des simulations avec des logiciels de calcul électromagnétique, de façon à optimiser les effets de couplage entre des motifs microstructurés adjacents de façon à augmenter le renforcement du champ électromagnétique. Plus précisément, en optimisant la distance entre les arêtes 29 de la couche extérieure 31 entourant deux motifs microstructurés adjacents, on peut encore optimiser le renforcement du champ électromagnétique en couplant l'effet de pointe généré par les couches métalliques 40 ou 41 situées sur les extrémités des arêtes 29. On optimise ainsi le confinement du champ électromagnétique créé dans l'espace 30 formé entre ces deux arêtes 29. Cette optimisation de la distance d1 entre les arêtes 29 de la couche métallique extérieure 31 est de préférence effectuée grâce à un logiciel de calcul électromagnétique. Cette distance d1 est de préférence comprise entre 1 nm et 50 nm. Une fois la distance d1 fixée, comme l'épaisseur de la multicouche 10 a été fixée précédemment au cours de l'étape de dimensionnement des cavités et des picots, on en déduit la distance d2 entre les arêtes 12 de deux motifs microstructurés adjacents 5.

### Choix de l'agencement de la structure porteuse :

Le procédé comporte également une étape de détermination de l'agencement de la structure porteuse.

La structure porteuse comporte de préférence plusieurs motifs microstructurés 5 sur lesquels sera déposée la multicouche. Ces motifs microstructurés 5 peuvent être isolés les uns des autres comme représenté sur la figure 14a ou alors ils peuvent former un réseau comme représenté sur la figure 14b. Le fait d'avoir des motifs microstructurés qui forment un réseau permet d'avoir une plus grande densité de points chauds.

Par ailleurs, dans le cas où les motifs microstructurés forment un réseau, la périodicité P du réseau formé peut être choisie de façon à optimiser l'amplification du champ électromagnétique émis en fonction de la longueur d'onde incidente pour laquelle le substrat est dimensionné. En effet, comme représenté sur les figures 8a et 8b, le champ électromagnétique varie en fonction de la périodicité de la structure porteuse.

La structure porteuse est de préférence dimensionnée de façon à former au moins un cristal photonique vis-à-vis de l'onde incidente envoyée sur le substrat, ce qui permet d'augmenter l'efficacité de couplage des couches métalliques avec la lumière incidente et donc d'augmenter le signal Raman. La structure porteuse peut former un cristal photonique puisque les couches de la multicouche sont réalisées en diélectrique. En outre, le support et la structure porteuse sont également réalisées dans des matériaux diélectriques. Dans ce mode de réalisation, le support 3 est de préférence en silicium et il est de préférence recouvert par une couche d'oxyde de silicium. La structure porteuse quant à elle est de préférence constituée de nitrure de silicium.

Les figures 17a à 17d représentent des exemples de géométries de cristaux photoniques respectivement à géométrie carrée, hexagonale, ou nid d'abeille et aléatoire pouvant être utilisées pour réaliser la structure porteuse.

Les figures 15a et 15b représentent un substrat selon un mode de réalisation de l'invention. Dans ce mode de réalisation, la structure porteuse est dimensionnée de façon à former des cavités résonnantes 42 vis-à-vis de l'onde incidente envoyée sur le substrat. Plus précisément, sur la figure 15a, la cristal photonique est dimensionné pour coupler l'onde incidente dans le plan du substrat.

Sur la figure 15b, le cristal photonique 42 est dimensionné pour extraire le signal Raman émis par les molécules d'intérêt hors du plan du substrat. Dans ce mode de réalisation, la structure porteuse est donc dimensionnée de façon à former un guide d'onde permettant d'extraire le signal Raman émis par les molécules déposées à la surface du substrat. La géométrie des cristaux photoniques formés par la structure porteuse est telle que la lumière émise par les molécules déposées à la surface du substrat soit diffractée perpendiculairement à la surface 4 du substrat, c'est-à-dire au point ┌ du diagramme de bande calculé par une méthode de domaine fréquentielle à base d'ondes (wave-basis frequency domain method) comme représenté sur la figure 16.

La structure porteuse permet donc de faciliter l'extraction du signal Raman émis par les molécules hors du substrat, de sorte que le substrat permet de faciliter la détection des molécules qui sont adsorbées à sa surface.

Ainsi, à partir du diagramme de bande de la figure 16, la structure porteuse peut former un cristal photonique avec une géométrie hexagonale présentant une période de 430 nm et une fréquence réduite de 0.55. Des périodes supérieures peuvent également être utilisées engendrant un diagramme annulaire d'émission plus important et donc un objectif de microscope d'ouverture numérique plus grande pourra être utilisée, comme par exemple des géométries de trous dans une couche de haut indice, ces géométries pouvant être hexagonale, en nid d'abeille, carrée ou encore aléatoire avec une période moyenne de 430 nm.

Naturellement, l'invention n'est pas limitée aux modes de réalisation décrits en référence aux figures et des variantes pourraient être envisagées sans sortir du cadre de l'invention définie par les revendications annexées.

## Revendications

1. Procédé de fabrication d'un substrat pour diffusion Raman exaltée de surface adapté pour recevoir une onde incidente à une longueur d'onde incidente, le procédé comportant les étapes suivantes :
- (101) réalisation d'une structure porteuse (2) sur une surface supérieure (4) d'un support (3), la structure porteuse (2) comportant au moins un motif microstructuré (5), le motif microstructuré (5) comportant un sommet (8) et des parois latérales (7), les parois latérales (7) s'étendant suivant une direction sécante à la direction de la surface supérieure (4);
- (102) dépôt d'une multicouche (10) sur la structure porteuse (2), la multicouche (10) comportant au moins deux couches d'un premier matériau diélectrique, dites « couches pilier » (13), séparées l'une de l'autre par une couche d'un deuxième matériau diélectrique, dite « couche intercalaire » (14), le deuxième matériau diélectrique pouvant être gravé sélectivement par rapport au premier matériau diélectrique;
- (103) gravure d'une partie de la multicouche (10) déposée sur le sommet (8) du motif microstructuré (5) de façon à exposer une extrémité (18, 19) de chaque couche (13, 14) de la multicouche (10);
- (104) gravure sélective d'une partie de chaque extrémité (18) de chaque couche intercalaire (14) de façon à former des cavités (20) entre les extrémités (19) de deux couches pilier successives;
- (105) dépôt d'une couche métallique (40) sur chaque extrémité (19) de chaque couche pilier (13).

2. Procédé selon la revendication précédente, comportant en outre une étape (106) de dépôt d'une couche métallique (41) sur chaque extrémité (18) de chaque couche intercalaire (14).

3. Procédé selon la revendication précédente, dans lequel, lors de l'étape de dépôt d'une couche métallique sur chaque extrémité de chaque couche pilier, la couche métallique est déposée par l'une des techniques suivantes : dépôt physique en phase vapeur, évaporation sous vide, ou encore par électrolyse.

4. Procédé selon l'une des revendications précédentes, dans lequel les couches (13, 14) de la multicouche (10) sont déposées suivant une technique de dépôt conforme.

5. Procédé selon l'une des revendications précédentes, dans lequel la gravure d'une partie de la multicouche (10) déposée sur le sommet (8) du motif microstructuré (5) est effectuée par polissage mécano-chimique.

6. Procédé selon l'une des revendications précédentes, dans lequel la structure porteuse est réalisée de façon à former un cristal photonique vis-à-vis d'une onde incidente éclairant le substrat.

7. Procédé selon l'une des revendications précédentes, dans lequel la structure porteuse est réalisée de façon à ce que les parois latérales (7) du motif microstructuré comportent des faces (11) séparées entre elles par des arêtes (12), l'angle de ces arêtes (12) étant choisi de façon à ce que la structure porteuse, une fois recouverte par la multicouche (10), génère un renforcement du champ électromagnétique par effet de pointe dans des zones (28) situées à proximité des arêtes (12).

8. Procédé selon l'une des revendications précédentes, dans lequel chaque motif microstructuré présente une hauteur comprise entre 50 nm et 100 µm.

9. Procédé selon l'une des revendications précédentes, dans lequel chaque couche de la multicouche présente une épaisseur comprise entre 1 angström et 100 nm, et de préférence entre 10 nm et 50 nm.

10. Procédé selon l'une des revendications précédentes, dans lequel la multicouche présente une épaisseur inférieure à la hauteur du motif microstructuré.

11. Procédé selon l'une des revendications précédentes, dans lequel les parois latérales du motif microstructuré s'étendent suivant une direction qui forme un angle strictement inférieur à 90° avec une direction normale à la surface supérieure du support.

12. Substrat pour diffusion Raman exaltée de surface adapté pour recevoir une onde incidente à une longueur d'onde incidente comportant :
- un support (3) comportant une surface supérieure (4);
- une structure porteuse (2) disposée sur la surface supérieure (4) du support (3), la structure porteuse (2) comportant au moins un motif microstructuré (5), le motif microstructuré (5) comportant un sommet (8) et des parois latérales (7), les parois latérales (7) s'étendant suivant une direction sécante à la direction de la surface supérieure (4);
- une multicouche (10) disposée sur les parois latérales (7) du motif microstructuré (5), la multicouche (10) comportant au moins deux couches d'un premier matériau diélectrique, dites « couches pilier » (13), séparées l'une de l'autre par une couche d'un deuxième matériau diélectrique, dite « couche intercalaire » (14), le deuxième matériau diélectrique pouvant être gravé sélectivement par rapport au premier matériau diélectrique, chaque couche intercalaire (14) présentant une extrémité (18) en retrait par rapport à une extrémité (19) de chaque couche pilier (13) adjacente de sorte que les extrémités (19) de deux couches pilier (13) successives forment des picots séparés par une cavité (20), les extrémités (19) des couches pilier (13) étant recouvertes par une couche métallique (40),
la structure porteuse:
- étant dimensionnée de façon à former un cristal photonique vis-à-vis de l'onde incidente éclairant le substrat et/ou
- étant telle que les parois latérales (7) du motif microstructuré comportent des faces (11) séparées entre elles par des arêtes (12), l'angle de ces arêtes (12) étant choisi de façon à ce que la structure porteuse, une fois recouverte par la multicouche (10), génère un renforcement du champ électromagnétique par effet de pointe dans des zones (28) situées à proximité des arêtes (12).

13. Substrat selon la revendication précédente, dans lequel l'extrémité de (18) chaque couche intercalaire (14) est également recouverte d'une couche métallique (41).

14. Substrat selon les revendications 12 et 13, dans lequel la couche métallique (41) déposée sur l'extrémité (18) d'une couche intercalaire (14) est disjointe la couche métallique (40) déposée sur l'extrémité (19) de la couche pilier (13) adjacente à cette couche intercalaire (14).

15. Substrat selon la revendication précédente, dans lequel la couche métallique (41) déposée sur l'extrémité (18) d'une couche intercalaire (14) est séparée de la couche métallique (40) déposée sur l'extrémité (19) de la couche pilier (13) adjacente à cette couche intercalaire (14) d'une distance (H3-H1-H2) comprise entre 1 nm et 40 nm, et préférence entre 10 nm et 30 nm.

## Patentansprüche

1. Verfahren zur Herstellung eines Substrats zur oberflächenverstärkten Ramen-Streuung, das zum Empfang einer einfallenden Welle mit einer einfallenden Wellenlänge geeignet ist, wobei das Verfahren die folgenden Schritte aufweist:
- (101) Herstellen einer tragenden Struktur (2) auf einer oberen Oberfläche (4) eines Trägers (3), wobei die tragende Struktur (2) mindestens ein mikrostrukturiertes Motiv (5) aufweist, wobei das mikrostrukturierte Motiv (5) eine Spitze (8) und Seitenwände (7) aufweist, wobei sich die Seitenwände (7) gemäß einer zur Richtung der oberen Oberfläche (4) schneidenden Richtung erstrecken;
- (102) Aufbringen einer Vielfachschicht (10) auf die tragende Struktur (2), wobei die Vielfachschicht (10) mindestens zwei Schichten eines ersten dielektrischen Materials, bezeichnet als "Stützschichten" (13), aufweist, die durch eine Schicht eines zweiten dielektrischen Materials, bezeichnet als "Zwischenschicht" (14), voneinander getrennt sind, wobei das zweite dielektrische Material in Bezug auf das erste dielektrische Material selektiv graviert sein kann;
- (103) Gravieren eines Teils der auf die Spitze (8) des mikrostrukturierten Motivs (5) aufgebrachten Vielfachschicht (10), so dass ein Ende (18, 19) jeder Schicht (13, 14) der Vielfachschicht (10) exponiert wird;
- (104) selektives Gravieren eines Teils jedes Endes (18) jeder Zwischenschicht (14), so dass Hohlräume (20) zwischen den Enden (19) von zwei aufeinanderfolgenden Stützschichten gebildet werden;
- (105) Aufbringen einer Metallschicht (40) auf jedes Ende (19) jeder Stützschicht (13).

2. Verfahren nach vorangehendem Anspruch, aufweisend ferner einen Schritt (106) des Aufbringens einer Metallschicht (41) auf jedes Ende (18) jeder Zwischenschicht (14).

3. Verfahren nach vorangehendem Anspruch, wobei beim Schritt des Aufbringens einer Metallschicht auf jedes Ende jeder Stützschicht die Metallschicht mittels einer der folgenden Techniken aufgebracht wird: physikalisches Aufbringen in der Dampfphase, Vakuumverdampfung oder auch durch Elektrolyse.

4. Verfahren nach einem der vorangehenden Ansprüche, wobei die Schichten (13, 14) der Vielfachschicht (10) gemäß einer entsprechenden Technik des Aufbringens aufgebracht werden.

5. Verfahren nach einem der vorangehenden Ansprüche, wobei die Gravur eines Teils der auf die Spitze (8) des mikrostrukturierten Motivs (5) aufgebrachten Vielfachschicht (10) durch mechanisch-chemische Politur durchgeführt wird.

6. Verfahren nach einem der vorangehenden Ansprüche, wobei die tragende Struktur derart hergestellt ist, dass ein photonischer Kristall gegenüber einer einfallenden Welle, die das Substrat beleuchtet, gebildet wird.

7. Verfahren nach einem der vorangehenden Ansprüche, wobei die tragende Struktur derart hergestellt wird, dass die Seitenwände (7) des mikrostrukturierten Motivs Flächen (11) aufweisen, die durch Kanten (12) voneinander getrennt sind, wobei der Winkel dieser Kanten (12) derart gewählt ist, dass die tragende Struktur, sobald sie von der Vielfachschicht (10) bedeckt ist, eine Verstärkung des elektromagnetischen Feldes durch Spitzenwirkung in Zonen (28) generiert, die sich in der Nähe der Kanten (12) befinden.

8. Verfahren nach einem der vorangehenden Ansprüche, wobei jedes mikrostrukturierte Motiv eine Höhe aufweist, die zwischen 50 nm und 100 µm liegt.

9. Verfahren nach einem der vorangehenden Ansprüche, wobei jede Schicht der Vielfachschicht eine Stärke aufweist, die zwischen 1 Angström und 100 nm und vorzugsweise zwischen 10 nm und 50 nm liegt.

10. Verfahren nach einem der vorangehenden Ansprüche, wobei die Vielfachschicht eine Stärke aufweist, die unter der Höhe des mikrostrukturierten Motivs ist.

11. Verfahren nach einem der vorangehenden Ansprüche, wobei sich die Seitenwände des mikrostrukturierten Motivs gemäß einer Richtung erstrecken, die mit einer normalen Richtung zu der oberen Oberfläche des Trägers einen Winkel von strikt kleiner als 90° bilden.

12. Substrat zur oberflächenverstärkten Ramen-Streuung, das zum Empfang einer einfallenden Welle mit einer einfallenden Wellenlänge geeignet ist, aufweisend:
- einen Träger (3), der eine obere Oberfläche (4) aufweist;
- eine tragende Struktur (2), die auf der oberen Oberfläche (4) des Trägers (3) angeordnet ist, wobei die tragende Struktur (2) mindestens ein mikrostrukturiertes Motiv (5) aufweist, wobei das mikrostrukturierte Motiv (5) eine Spitze (8) und Seitenwände (7) aufweist, wobei sich die Seitenwände (7) gemäß einer zur Richtung der oberen Oberfläche (4) schneidenden Richtung erstrecken;
- eine Vielfachschicht (10), die auf den Seitenwänden (7) des mikrostrukturierten Motivs (5) aufgebracht ist, wobei die Vielfachschicht (10) mindestens zwei Schichten eines ersten dielektrischen Materials, bezeichnet als "Stützschichten" (13), aufweist, die durch eine Schicht eines zweiten dielektrischen Materials, bezeichnet als "Zwischenschicht" (14), voneinander getrennt sind, wobei das zweite dielektrische Material in Bezug auf das erste dielektrische Material selektiv graviert sein kann, wobei jede Zwischenschicht (14) ein in Bezug auf ein Ende (19) jeder anliegenden Stützschicht (13) zurückgezogenes Ende (18) aufweist, so dass die Enden (19) von zwei aufeinanderfolgenden Stützschichten (13) Zapfen bilden, die durch einen Hohlraum (20) getrennt sind, wobei die Enden (19) der Stützschichten (13) von einer Metallschicht (40) bedeckt sind,
wobei die tragende Struktur:
- derart bemessen ist, dass ein photonischer Kristall gegenüber der einfallenden Welle, die das Substrat beleuchtet, gebildet wird und/oder
- derart ist, dass die Seitenwände (7) des mikrostrukturierten Motivs Flächen (11) aufweisen, die durch Kanten (12) voneinander getrennt sind, wobei der Winkel dieser Kanten (12) derart gewählt ist, dass die tragende Struktur, sobald sie von der Vielfachschicht (10) bedeckt ist, eine Verstärkung des elektromagnetischen Feldes durch Spitzenwirkung in Zonen (28) generiert, die sich in der Nähe der Kanten (12) befinden.

13. Substrat nach vorangehendem Anspruch, wobei das Ende (18) jeder Zwischenschicht (14) ebenfalls mit einer Metallschicht (41) bedeckt ist.

14. Substrat nach den Ansprüchen 12 und 13, wobei die auf das Ende (18) einer Zwischenschicht (14) aufgebrachte Metallschicht (41) von der Metallschicht (40), die auf das Ende (19) der an dieser Zwischenschicht (14) anliegen Stützschicht (13) aufgebracht ist, gelöst ist.

15. Substrat nach vorangehendem Anspruch, wobei die auf ein Ende (18) einer Zwischenschicht (14) aufgebrachte Metallschicht (41) von der Metallschicht (40), die auf das Ende (19) der an dieser Zwischenschicht (14) anliegenden Stützschicht (13) aufgebracht ist, in einem Abstand (H3-H1-H2) getrennt ist, der zwischen 1 nm und 40 nm und vorzugsweise zwischen 10 nm und 30 nm liegt.

## Claims

1. Method for manufacturing a substrate for surface-enhanced Raman spectography adapted to receive an incident wave at an incident wavelength, with the method comprising the following steps:
- (101) creating a supporting structure (2) on an upper surface (4) of a support (3), with the supporting structure (2) comprising at least one microstructured pattern (5), the microstructured pattern (5) comprising a top (8) and sidewalls (7), with the sidewalls (7) extending according to a direction secant to the direction of the upper surface (4);
- (102) depositing of a multilayer (10) on the supporting structure (2), with the multilayer (10) comprising at least two layers of a first dielectric material, referred to as "pillar layers" (13), separated from one another by a layer of a second dielectric material, referred to as "intermediate layer" (14), the second dielectric material that can be selectively etched in relation to the first dielectric material;
- (103) etching of a portion of the multilayer (10) deposited on the top (8) of the microstructured pattern (5) in such a way as to expose an end (18, 19) of each layer (13, 14) of the multilayer (10);
- (104) selective etching of a portion of each end (18) of each intermediate layer (14) in such a way as to form cavities (20) between the ends (19) of two successive pillar layers;
- (105) depositing of a metal layer (40) on each end (19) of each pillar layer (13).

2. Method as claimed in the preceding claim, further comprising a step (106) of depositing a metal layer (41) on each end (18) of each intermediate layer (14).

3. Method as claimed in the preceding claim, wherein, during the step of depositing a metal layer on each end of each pillar layer, the metal layer is deposited by one of the following techniques: physical vapour deposition, vacuum evaporation, or by electrolysis.

4. Method according to one of the preceding claims, wherein the layers (13, 14) of the multilayer (10) are deposited according to a compliant depositing technique.

5. Method according to one of the preceding claims, wherein the etching of a portion of the multilayer (10) deposited on the top (8) of the microstructured pattern (5) is carried out by chemical mechanical planarisation.

6. Method according to one of the preceding claims, wherein the supporting structure is carried out in such a way as to form a photonic crystal with respect to an incident wave illuminating the substrate.

7. Method according to one of the preceding claims, wherein the supporting structure is carried out in such a way that the sidewalls (7) of the microstructured pattern comprise faces (11) separated from each other by edges (12), the angle of these edges (12) being chosen in such a way that the supporting structure, once covered by the multilayer (10), generates a reinforcing of the electromagnetic field via the point effect in zones (28) located in the vicinity of the edges (12).

8. Method according to one of the preceding claims, wherein each microstructured pattern has a height between 50 nm and 100 µm.

9. Method according to one of the preceding claims, wherein each layer of the multilayer has a thickness between 1 angstrom and 100 nm, and preferably between 10 nm and 50 nm.

10. Method according to one of the preceding claims, wherein the multilayer has a thickness less than the height of the microstructured pattern.

11. Method according to one of the preceding claims, wherein the sidewalls of the microstructured pattern extend according to a direction that forms an angle strictly less than 90° with a direction normal to the upper surface of the support.

12. Substrate for surface-enhanced Raman spectography adapted to receive an incident wave at an incident wavelength comprising:
- a support (3) comprising an upper surface (4);
- a supporting structure (2) arranged on the upper surface (4) of the support (3), with the supporting structure (2) comprising at least one microstructured pattern (5), the microstructured pattern (5) comprising a top (8) and sidewalls (7), with the sidewalls (7) extending according to a direction secant to the direction of the upper surface (4);
- a multilayer (10) arranged on the sidewalls (7) of the microstructured pattern (5), with the multilayer (10) comprising at least two layers of a first dielectric material, referred to as "pillar layers" (13), separated from one another by a layer of a second dielectric material, referred to as "intermediate layer" (14), the second dielectric material that can be selectively etched in relation to the first dielectric material, each intermediate layer (14) having an end (18) set back with respect to an end (19) of each adjacent pillar layer (13) in such a way that the ends (19) of two successive pillar layers (13) form pins separated by a cavity (20), with the ends (19) of the pillar layers (13) being covered by a metal layer (40),
the supporting structure:
- being dimensioned in such a way as to form a photonic crystal with respect to the incident wave illuminating the substrate and/or
- being such that the sidewalls (7) of the microstructured pattern comprise faces (11) separated from each other by edges (12), the angle of these edges (12) being chosen in such a way that the supporting structure, once covered by the multilayer (10), generates a reinforcing of the electromagnetic field via the point effect in zones (28) located in the vicinity of the edges (12).

13. Substrate as claimed in the preceding claim, wherein the end of (18) each intermediate layer (14) is also covered with a metal layer (41).

14. Substrate according to claims 12 and 13, wherein the metal layer (41) deposited on the end (18) of an intermediate layer (14) is separated from the metal layer (40) deposited on the end (19) of the pillar layer (13) adjacent to this intermediate layer (14).

15. Substrate as claimed in the preceding claim, wherein the metal layer (41) deposited on the end (18) of an intermediate layer (14) is separated from the metal layer (40) deposited on the end (19) of the pillar layer (13) adjacent to this intermediate layer (14) by a distance (H3-H1-H2) between 1 nm and 40 nm, and preferably between 10 nm and 30 nm.
